# EUROPEAN PATENT APPLICATION

(11) **EP 4 700 828 A1**
(43) Date of publication of application: **25.02.2026**
(21) Application number: 25150158.1
(22) Date of filing: 03.01.2025
(51) Int. Cl.: H01L 23/14, H01L 23/367, H01L 23/373, H01L 23/46, H01L 23/467, H01L 23/473

(54) **HEAT SINK, THERMAL MODULE AND ELECTRONIC DEVICE**

(30) Priority: 19.08.2024 TW 113131161
(71) Applicant: Industrial Technology Research Institute, 310401 Hsinchu (TW)
(72) Inventor: Wang, Yu-Chih, 106639 Taipei City (TW); Chen, Wen-Chih, 302 Zhubei City, Hsinchu County (TW); Liu, Chun-Kai, 300052 Hsinchu City (TW); Chiu, Po-Kai, 330 Taoyuan City (TW); Wang, Ting-Yu, 831 Kaohsiung City (TW)
(74) Representative: Kurig, Thomas

(57) **Abstract**

A heat sink (10), a thermal module (6), and an electronic device (2) are provided. The heat sink (10) includes a base (11) and a plurality of curved fins (12) arranged in parallel on the base (11). Each curved fin (12) has a plurality of wave peaks (12a), with a pitch (P) defined between any two adjacent wave peaks (12a), and at least two of the plurality of wave peaks (12a) are different.

## Description

### TECHNICAL FIELD

The disclosure relates to a heat sink, a thermal module, and an electronic device.

### BACKGROUND

The electric vehicle industry has experienced rapid growth in recent years, resulting in an increasing need for heat dissipation technologies in electrical systems. Heat sinks have been utilized in various applications to manage heat produced during high-power operations, where the ability to handle significant heat loads in a compact and lightweight form factor is crucial. Effective heat dissipation can contribute to overall system stability without compromising vehicle efficiency or performance.

Efficient thermal management systems are critical in maintaining the performance and extending the service life of power modules, which can be adversely affected by overheating. Continued developments in heat dissipation technology are essential to improve the reliability of power systems and reduce operational maintenance costs.

### SUMMARY

The disclosure provides a heat sink with a novel structure.

The disclosure provides an electronic device with a novel heat sink structure.

The disclosure provides a thermal module using a novel arrangement.

The disclosure provides an electronic device with a novel heat sink structure.

The disclosure provides a heat sink including a base and a plurality of curved fins arranged in parallel on the base. Each curved fin has a plurality of wave peaks, with a pitch defined between any two adjacent wave peaks, and at least two of the wave peaks are different.

In one embodiment, curved shapes of two adjacent curved fins arranged in parallel are different.

In one embodiment, the heat sink further includes a cover covering the base, and the curved fins are located in a space formed by the cover and the base. The cover has a first surface facing the base, the curved fins have a second surface facing the cover, and the second surface has a varying distance from the first surface.

In one embodiment, the heat sink further includes a plurality of ribs arranged in flow channels defined by the curved fins. A length direction of the ribs is substantially perpendicular to a flow direction of fluids in the flow channels.

In one embodiment, two adjacent curved fins in parallel define a flow channel, and surfaces of the curved fins on both sides of the flow channel have different surface roughness.

In one embodiment, heights of the wave peaks are different.

In one embodiment, thicknesses of the curved fins are different.

In one embodiment, widths of the curved fins are different.

The disclosure further provides an electronic device including a power component and a heat sink. The power component includes a substrate, a first metal layer, a second metal layer, and a plurality of power semiconductor elements. The substrate is made of a semiconductor material and has a first contact surface and a second contact surface on two opposite sides. The first metal layer is on the first contact surface. The second metal layer is on the second contact surface. The power semiconductor elements are on the first metal layer. The heat sink on the power component includes a base and a plurality of curved fins. The curved fins are arranged in parallel on the base. Each curved fin has a plurality of wave peaks, with a pitch defined between any two adjacent wave peaks. Each curved fin has at least one first pitch and one second pitch, and the first pitch is greater than the second pitch.

In one embodiment, curved shapes of two adjacent curved fins arranged in parallel are different.

In one embodiment, the heat sink further includes a cover covering the base, and the curved fins are located in a space formed by the cover and the base. The cover has a first surface facing the base, the curved fins have a second surface facing the cover, and the second surface has a varying distance from the first surface.

In one embodiment, the heat sink further includes a plurality of ribs arranged in a plurality of flow channels defined by the curved fins. A length direction of the ribs is substantially perpendicular to a flow direction of fluids in the flow channels.

In one embodiment, two adjacent curved fins in parallel define a flow channel, and surfaces of the curved fins on both sides of the flow channel have different surface roughness.

In one embodiment, heights of the wave peaks are different.

In one embodiment, thicknesses of the curved fins are different.

In one embodiment, widths of the curved fins are different.

The disclosure further provides a thermal module including at least one power semiconductor element, a plurality of heat sinks, and a cover. The cover has a fluid inlet and a fluid outlet. The power semiconductor element and the heat sinks are positioned between the fluid inlet and the fluid outlet, with the power semiconductor element and the plurality of heat sinks sandwiching the cover. Each heat sink includes a base and a plurality of curved fins arranged in parallel on the base. The curved fins arranged in parallel define a plurality of flow channels extending in a first direction. A depth direction of the fluid inlet defines a second direction perpendicular to the first direction.

In one embodiment, curved shapes of two adjacent curved fins arranged in parallel are different.

In one embodiment, the cover has a first surface facing the base, the curved fins have a second surface facing the cover, and the second surface has a varying distance from the first surface.

In one embodiment, the thermal module further includes a plurality of ribs arranged in the flow channels. A length direction of the plurality of ribs is substantially perpendicular or inclined to the first direction.

In one embodiment, surfaces of the curved fins on both sides of each flow channel have different surface roughness.

In one embodiment, each curved fin has a plurality of wave peaks, and heights of the wave peaks are different.

In one embodiment, thicknesses of the curved fins are different.

In one embodiment, widths of the curved fins are different.

The disclosure further provides an electronic device including a plurality of power semiconductor elements and a heat sink including a base and a plurality of curved fins arranged in parallel on the base. The curved fins have different shapes. Two adjacent curved fins define a flow channel. Each flow channel is configured to accommodate a fluid with a flow rate, and the flow rates in the plurality of flow channels are not the same. The power semiconductor elements are positioned on the base corresponding to the flow channels with higher flow rates.

In one embodiment, curved shapes of two adjacent curved fins arranged in parallel are different.

In one embodiment, the heat sink further includes a cover covering the base, and the curved fins are located in a space formed by the cover and the base.

In one embodiment, the cover has a first surface facing the base, the curved fins have a second surface facing the cover, and the second surface has a varying distance from the first surface.

In one embodiment, the heat sink further includes a plurality of ribs arranged in the flow channels. A length direction of the ribs is substantially perpendicular to a first direction, and the first direction is an extending direction of the flow channels.

In one embodiment, surfaces of the curved fins on both sides of each flow channel have different surface roughness.

In one embodiment, each curved fin has a plurality of wave peaks, and heights of the wave peaks are different.

In one embodiment, thicknesses of the curved fins are different.

In one embodiment, widths of the curved fins are different.

In view of the above, in the disclosure, the heat sink, electronic device, and thermal module effectively enhance overall heat dissipation efficiency by adopting a novel structural arrangement. Therefore, when a fluid (e.g., liquid or gas) enters the flow channel between two adjacent and identical curved fins, the fluid changes its direction and velocity according to the bending angle and the width of the flow channel, so that the flow rate of the fluid increases, and that the temperature accompanying the operation of the power component drops.

Several exemplary embodiments accompanied with figures are described in detail below to further describe the disclosure in details.

### BRIEF DESCRIPTION OF THE DRAWINGS

The accompanying drawings are included to provide a further understanding, and are incorporated in and constitute a part of this specification. The drawings illustrate exemplary embodiments and, together with the description, serve to explain the principles of the disclosure.
FIG. 1A is a perspective view of a heat sink according to one embodiment of the disclosure.
FIG. 1B is a top view of a local portion of the heat sink of FIG. 1A.
FIG. 1C is a schematic view of another pitch variation of a curved fin.
FIG. 1D is a schematic view of still another pitch variation of the curved fin.
FIG. 1E is a schematic view of yet another pitch variation of the curved fin.
FIG. 1F is a schematic view of the heat sink applied in an electronic device.
FIG. 1G is a schematic view of another implementation of a power component.
FIG. 2 is a schematic view of two adjacent curved fins in the heat sink having different curved shapes.
FIG. 3A is a schematic view of the heat sink with flow channels having different flow rates.
FIG. 3B is a schematic view of the heat sink of FIG. 3A applied in the electronic device.
FIG. 4A is an exploded schematic view of a base and a cover.
FIG. 4B is a cross-sectional schematic view of the base and cover of FIG. 4A after assembly.
FIG. 4C is a schematic view of inclined arrangement of the curved fins.
FIG. 4D is a schematic view of a second surface defined by the curved fins inclined relative to a first surface of the cover.
FIG. 4E is a schematic view of the curved fins protruding from the base at different lengths.
FIG. 4F is a schematic view of the second surface of the curved fins facing the cover having varying distances relative to the first surface of the cover.
FIG. 5A is a schematic view of arrangement of ribs in the flow channels.
FIG. 5B is a schematic view of arrangement of a length direction of the ribs inclined to a first direction.
FIG. 6A is a schematic view of the heat sink applied in a thermal module.
FIG. 6B is a top view of a cross-section taken along the A-A section line of FIG. 6A.
FIG. 7 is a schematic view of the thermal module according to the second embodiment of the disclosure.

### DETAILED DESCRIPTION OF DISCLOSURED EMBODIMENTS

### First Embodiment

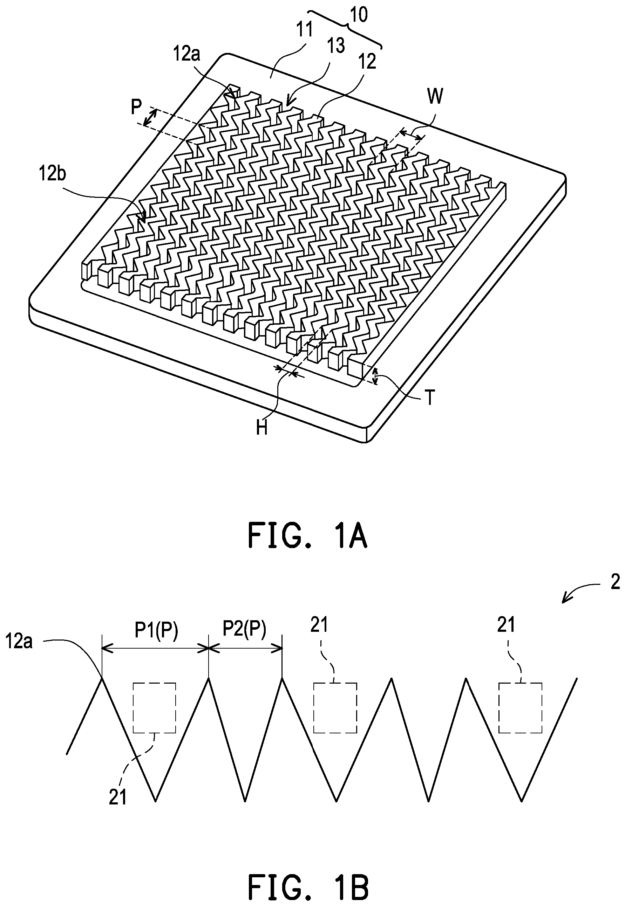

FIG. 1A is a perspective view of a heat sink according to one embodiment of the disclosure, and FIG. 1B is a top view of a local portion of the heat sink of FIG. 1A. With reference to FIG. 1A and FIG. 1B together, in one embodiment, a heat sink 10 includes a base 11 and a plurality of curved fins 12 arranged in parallel on the base 11. A flow channel 13 is formed between any two adjacent curved fins 12. Each curved fin 12 has a plurality of wave peaks 12a, with a pitch P between any two adjacent wave peaks 12a define. Not all of these pitches P in these wave peaks 12a are the same, which means that some of these pitches P are the same while the remaining are different. In other words, the pitches P mentioned herein that are not all the same include multiple different arrangements set according to the sizes and arrangement of the pitches, but the arrangements are not limited to herein and may be set according to actual situations.

According to one embodiment, at least any two of these multiple pitches P are not the same.

According to one embodiment, each curved fin 12 includes a plurality of arranged first pitches P1 and a plurality of arranged second pitches P2, and sizes of the first pitches P1 and the second pitches P2 are different. In this case, these first pitches P1 are arranged in odd numbers and these second pitches P2 are arranged in even numbers, resulting in the first pitches P1 and the second pitches P2 being arranged in an alternating manner in sequence. According to another embodiment, multiple second pitches P2 are arranged between any two of these first pitches P1. For instance, two or more second pitches P2 are arranged between two first pitches P1, resulting in two or more second pitches P2 between every two first pitches P1. In other words, the numbers and sizes of these pitches are arranged according to actual needs and are not limited herein. Therefore, when a fluid (e.g., liquid or gas) enters the flow channel 13 between two adjacent curved fins 12, the fluid changes its direction and velocity according to a bending angle and a width of the flow channel 13, so that a turbulence level and a local microscopic region flow rate of the fluid increase, and that a temperature accompanying the operation of a power component drops. The arrangement relationship between the heat sink 10 and the power component is described in detail in the following paragraphs.

According to one embodiment, each curved fin 12 formed by multiple wave peaks includes a first pitch P1, a second pitch P2, and a third pitch arranged in sequence. The first pitch P1 and the second pitch P2 are adjacent and have a same size, but a size of the third pitch is different from the sizes of the first pitch P1 and the second pitch P2. In another embodiment, the sizes of the first pitch P1 to the third pitch may be completely different. In other words, the numbers and sizes of these pitches are arranged according to actual needs and are not limited herein. Therefore, when a fluid (e.g., liquid or gas) enters the flow channel 13 between two adjacent and identical curved fins 12, the fluid changes its direction and velocity according to the bending angle and the width of the flow channel 13, so that the turbulence level and the local microscopic region flow rate of the fluid increase, and that the temperature accompanying the operation of the power component drops.

According to one embodiment, some of the pitches P owned by some curved fins 12 may be the same as the pitches P owned by other curved fins 12, and positions of these identical pitches P may not correspond to each other.

Since any two adjacent wave peaks 12a among the multiple wave peaks 12a owned by each curved fin 12 may define one pitch P, each curved fin 12 has multiple pitches P, and these pitches P are designed to be not entirely identical. In this way, when the fluid enters the heat sink 10, by means of the structural design where the pitches P of each curved fin 12 are not entirely the same, the fluid flowing in the flow channel 13 generates different flow rates corresponding to different pitch P positions to conduct heat transfer more effectively, the overall heat dissipation effect of the heat sink 10 is thereby enhanced.

As shown in FIG. 1B, the curved fin 12 has the first pitches P1 and the second pitches P2. The first pitches P1 are greater than the second pitches P2, and the first pitches P1 and the second pitches P2 are arranged in an alternating manner in sequence. When the fluid flows through regions corresponding to the first pitches P1, the fluid has a higher flow rate, and when the fluid flows through regions corresponding to the second pitches P2, the fluid has a slower flow rate. By means of the alternating arrangement design of the first pitches P1 and the second pitches P2 of the curved fin 12, turbulence is formed when the fluid flows in the flow channel 13, and the formation of dead water zones and stagnation points in the flow channel 13 is thus prevented.

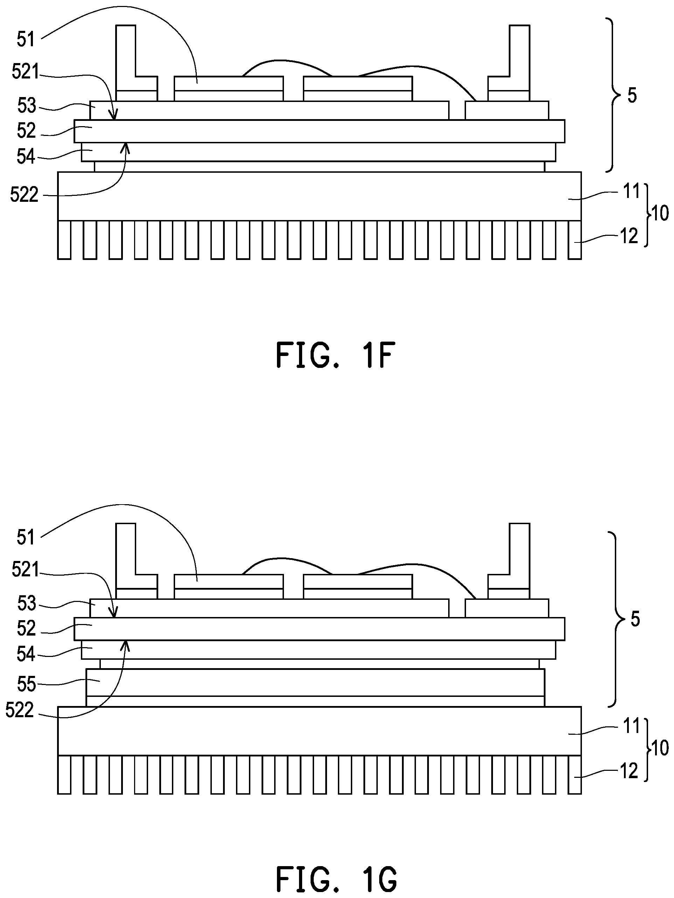

FIG. 1F is a schematic view of the heat sink applied in an electronic device. According to one embodiment, with reference to FIG. 1F, the heat sink 10 is applied in an electronic device 2 to dissipate heat from a power component 5 in the electronic device 2. To be specific, the electronic device 2 includes the power component 5 and the heat sink 10, with the heat sink 10 positioned on the power component 5. The power component 5 includes a substrate 52, a first metal layer 53, a second metal layer 54, and a plurality of power semiconductor elements 51. The substrate 52 is made of a semiconductor material and has a first contact surface 521 and a second contact surface 522 on two opposite sides. The first metal layer 53 is on the first contact surface 521. The second metal layer 54 is on the second contact surface 522. The power semiconductor elements 51 are on the first metal layer 53. Description of the heat sink 10 is provided in the foregoing paragraphs and thus is not repeated herein. When this power component 5 operates, the power component 5 generates a heat source 21. According to the heat source 21 accompanying this power component 5, the power component 5 is set at the position corresponding to the first pitch P1 in the heat sink 10, allowing the faster water flow to carry away the heat emitted by the heat source 21, and heat accumulation is thus prevented.

FIG. 1G is a schematic view of another implementation of a power component. With reference to FIG. 1G, in one embodiment, the power component 5 further includes a base plate 55 located between the second metal layer 54 and the base 11 of the heat sink 10, such that the opposite surfaces of the base plate 55 contact the base 11 and the second metal layer 54. In other words, the arrangement of the base plate 55 may be determined according to actual conditions and is not limited herein.

Besides, although the heat sink 10 shown in FIG. 1B is designed with alternating arrangement of the first pitches P1 and the second pitches P2, it is not limited thereto.

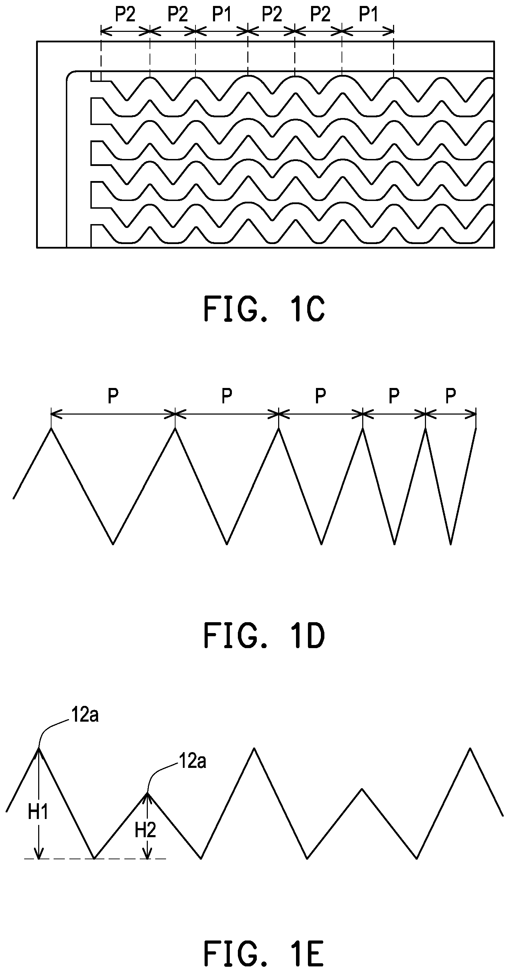

FIG. 1C is a schematic view of another pitch variation of a curved fin. With reference to FIG. 1C, in another implementation, the pitches P of the curved fin 12 may also be arranged randomly or in an orderly spaced arrangement according to needs, for example, second pitch P2, second pitch P2, first pitch P1, second pitch P2, second pitch P2, first pitch P1...

FIG. 1D is a schematic view of still another pitch variation of the curved fin. With reference to FIG. 1D, in another implementation, the pitches P of the curved fin 12 may also decrease gradually in one direction.

FIG. 1E is a schematic view of yet another pitch variation of the curved fin. As shown in FIG. 1E, the wave peaks 12a of the curved fin 12 may have different heights, where first wave peaks 12a with a first height H1 and second wave peaks 12a with a second height H2 are arranged in an alternating manner. In other words, another wave peak 12a with the second height H2 is inserted between two adjacent wave peaks 12a with the first height H1, and a wave peak 12a with the first height H1 is inserted between two adjacent wave peaks 12a with the second height H2. Through this design, it may also achieve the effect of generating turbulence to avoid the formation of dead water zones with stagnant water points in the flow channel 13 (shown in FIG. 1A).

In some embodiments that are not shown, another wave peak 12a with a height different from the first height H1 may also be inserted between two adjacent wave peaks 12a with the first height H1, such as a second wave peak, a third wave peak, or even a fourth wave peak. Further, the second wave peak, the third wave peak, the fourth wave peak... located between two adjacent wave peaks 12a with the first height H1 may have heights that are not entirely the same.

In various embodiments, different patterns of the pitches P can be implemented without being limited to the examples described above. The disclosed embodiments may allow for various modifications and alternatives in the arrangement of pitches, which can be adapted based on specific design requirements or applications.

Moreover, in addition to the variation of pitches P being able to enhance the heat dissipation effect of the heat sink 10, changes in the shape of the curved fins 12, a thickness T (from a top surface of one curved fin 12 to a top surface of the base) of the curved fins 12, a width W (distance from the wave peak to a trough) of the curved fins 12, a wave peak height H, shapes of the wave peak and trough, surface roughness, material type, etc., may also achieve the same effect.

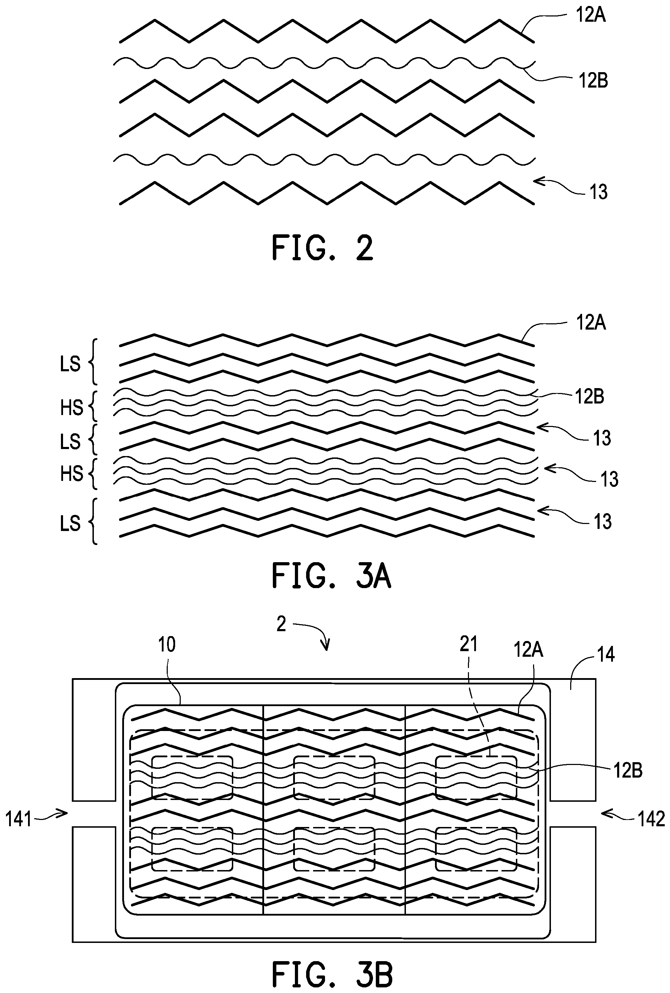

FIG. 2 is a schematic view of two adjacent curved fins in the heat sink having different curved shapes. With reference to FIG. 2, curved shapes of two adjacent curved fins 12 arranged in parallel may also be different. For instance, a first curved fin 12A on the upper side has a sharper curve, while a second curved fin 12B on the lower side has a more gradual curve.

Through this design where the shapes at the two side boundaries of the flow channel 13 are inconsistent, it may also achieve the purpose of generating turbulence to prevent the formation of dead water zones in the flow channel 13.

The first curved fin 12A and the second curved fin 12B that form one single flow channel 13 may further have different surface roughness to increase turbulence and to enhance the heat dissipation effect.

Extending from the aforementioned concept, the heat sink 10 may be designed to have flow channels 13 with different flow rates. FIG. 3A is a schematic view of the heat sink with flow channels having different flow rates. With reference to FIG. 3A, through the arrangement of the curved fins 12A and 12B with the same shape and different shapes, the heat sink 10 has flow channels 13 with different flow rates. As shown in the heat sink 10 in FIG. 3A, there are 8 curved fins 12A with sharper curves, of which 3 curved fins 12A are on a first side of the base 11 and 3 curved fins 12A are on a second side of the base 11, and the second side is opposite to the first side. 2 curved fins 12A are located in the middle of the base 11. In addition, the heat sink 10 also has 6 curved fins 12B with more gradual curves, and the 2 curved fins 12A located in the middle of the base 11 separate the 6 curved fins 12B apart.

Simply put, from the first side of the base 11 towards the second side, there is an arrangement of 3 curved fins 12A, 3 curved fins 12B, 2 curved fins 12A, 3 curved fins 12B, and 3 curved fins 12A.

Through this arrangement, high flow velocity zones HS are formed in the flow channels 13 created by the arrangement of the curved fins 12B, while low flow velocity zones LS are formed in the flow channels 13 created by the arrangement of the curved fins 12A.

FIG. 3B is a schematic view of the heat sink of FIG. 3A applied in the electronic device. With reference to FIG. 3B, description of the electronic device 2 and the heat sink 10 is provided in the foregoing paragraphs and thus is not repeated herein. In one embodiment, multiple power semiconductor elements 51 in the power component 5 are arranged at positions corresponding to flow channels 13 with higher flow rates, so that the temperature accompanying the power component 5 during operation drops. For instance, these power semiconductor elements 51 are located above the base 11 of the heat sink 10, and the flow channels 13 with higher flow rates are set at positions corresponding to these power semiconductor elements 51 in order to lower the temperature accompanying the power component 5 during operation. Through this arrangement, the heat generated by the heat source 21 may be quickly carried away.

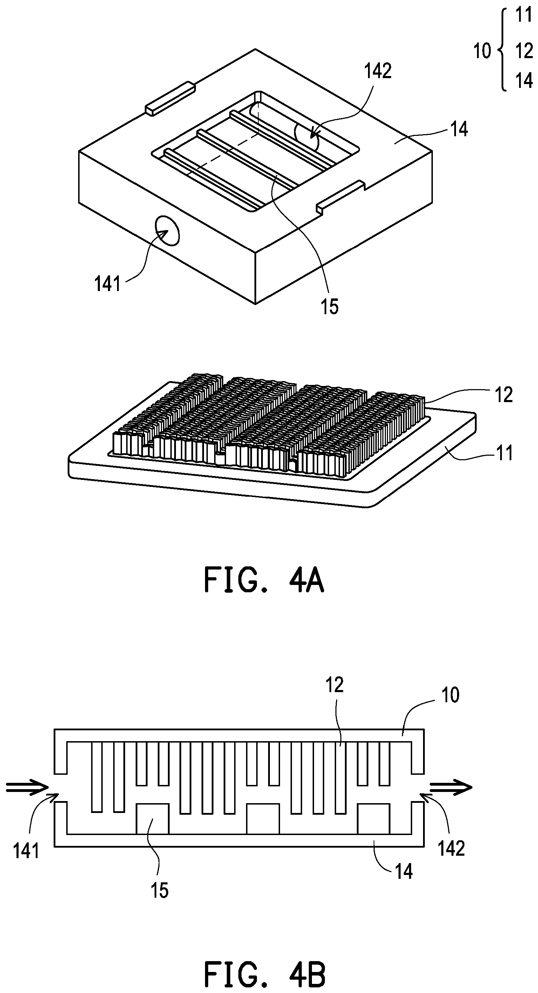

FIG. 4A is an exploded schematic view of a base and a cover, and FIG. 4B is a cross-sectional schematic view of the base and cover of FIG. 4A after assembly. With reference to FIG. 4A and FIG. 4B together, the heat sink 10 further includes a cover 14 that covers the base 11, and the curved fins 12 are located in a space formed by the cover 14 and the base 11.

The cover 14 covers the base 11 to form a nearly enclosed space, and this space allows a fluid to enter and exit by means of a fluid inlet 141 and a fluid outlet 142 set on opposite sides of the cover 14.

As can be seen from FIG. 4B, the length of the curved fins 12 corresponding to ribs 15 is shorter than the length of the curved fins 12 not corresponding to the ribs 15.

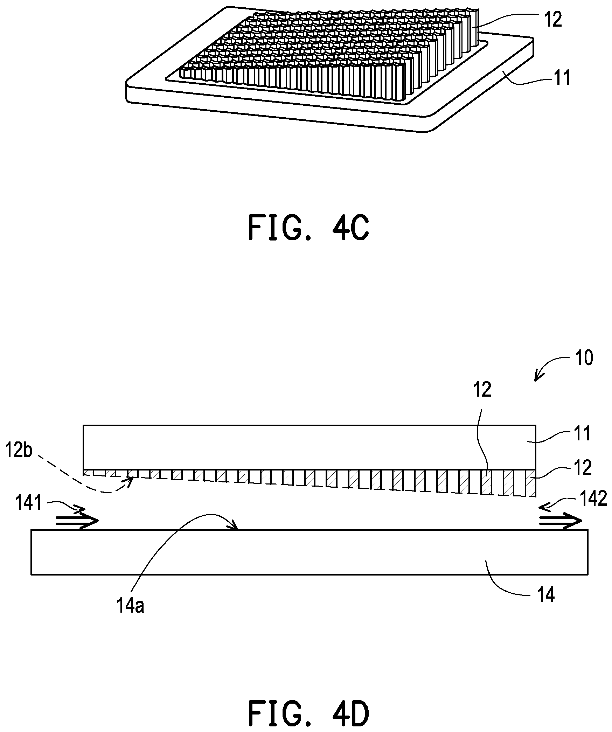

FIG. 4C is a schematic view of inclined arrangement of the curved fins, and FIG. 4D is a schematic view of a second surface defined by the curved fins inclined relative to a first surface of the cover. With reference to FIG. 4A, FIG. 4C, and FIG. 4D together, in this embodiment, the aforementioned cover 14 has a first surface 14a facing the base 11, and all the surfaces of the curved fins 12 facing the cover 14 define a second surface 12b facing the cover 14 together. The second surface 12b is inclined relative to the first surface 14a.

The fluid inlet 141 of the cover 14 is set corresponding to where the relative distance between the second surface 12b and the first surface 14a is larger, while the fluid outlet 142 of the cover 14 is set corresponding to where the relative distance between the second surface 12b and the first surface 14a is smaller. This arrangement may accelerate the flow rate of the fluid entering the space from the fluid inlet 141 and flowing out of the space from the fluid outlet 142.

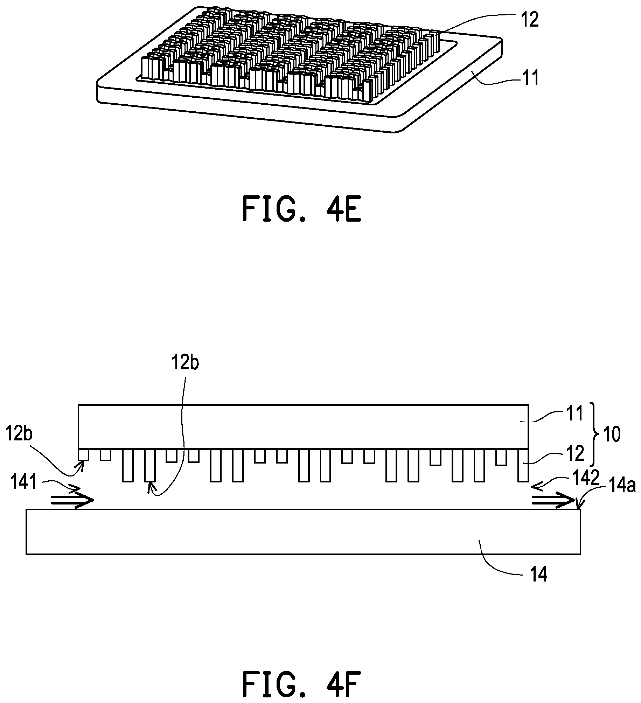

FIG. 4E is a schematic view of the curved fins protruding from the base at different lengths, and FIG. 4F is a schematic view of the second surface of the curved fins facing the cover having varying distances relative to the first surface of the cover. As shown in FIG. 4E and FIG. 4F, it may also be implemented by having different curved fins 12 protrude from the base 11 at different lengths, causing the distance between the second surface 12b of the individual curved fins 12 facing the cover 14 and the first surface 14a of the cover 14 facing the curved fins 12 to vary. In this way, the purpose of generating turbulent flow to enhance the heat dissipation effect may also be achieved.

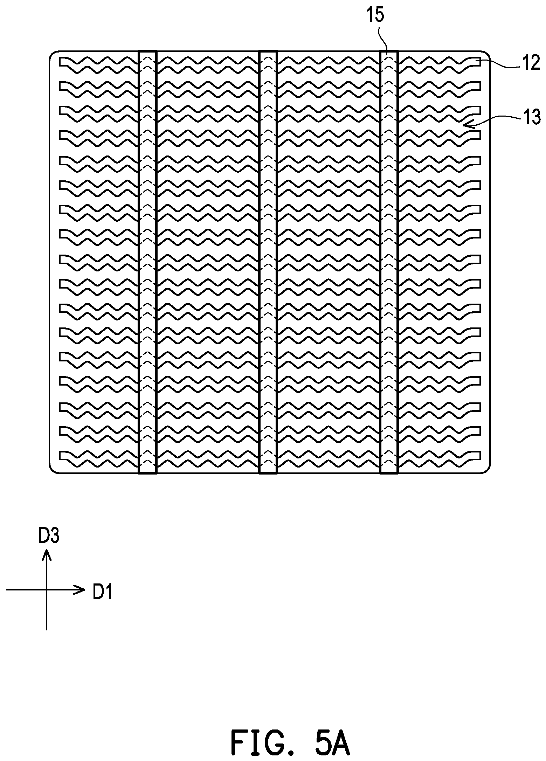

FIG. 5A is a schematic view of arrangement of ribs in the flow channels. With reference to FIG. 4A and FIG. 5A together, the aforementioned heat sink 10 further includes multiple ribs 15 set in the flow channels 13 defined by the curved fins 12. A length direction D3 of the ribs 15 is perpendicular to a flow direction (first direction D1) of fluids in the flow channels 13. In one embodiment, a length direction D3 of these ribs 15 is substantially perpendicular to the flow direction (first direction D1) of the fluids in the flow channels 13. The term "substantially perpendicular to" used herein refers to an angle of the length direction D3 in the first direction D1 including an error range of approximately ±5% to ±10% from a right angle.

In this embodiment, the ribs 15 are formed on the cover 14, the fluid inlet 141 and the fluid outlet 142 are set on opposite sides of the cover 14, and an extending direction of the fluid inlet 141 and the fluid outlet 142 is parallel to an extending direction of the flow channels 13. That is, the extending direction of the fluid inlet 141 and the fluid outlet 142 is parallel to the flow direction (first direction D1) of the fluids.

The ribs 15 are arranged on the other two opposite sides of the cover 14 where the fluid inlet 141 and the fluid outlet 142 are not arranged, and the length direction D3 of the ribs 15 is perpendicular to the extending direction (first direction D1) of the fluid inlet 141 and the fluid outlet 142.

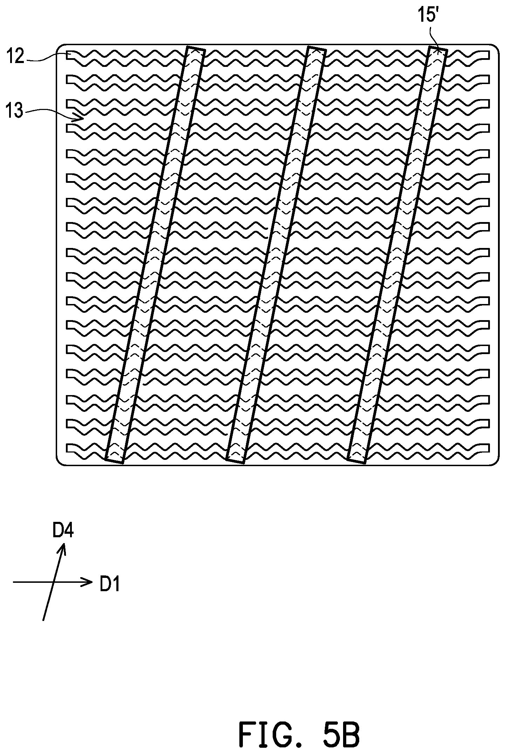

FIG. 5B is a schematic view of arrangement of a length direction of the ribs inclined to a first direction. With reference to FIG. 5B, In one embodiment, these ribs 15' may also be arranged inclined to the extending direction (first direction D1) of the fluid inlet 141 and the fluid outlet 142, and a length direction D4 of the ribs 15' is inclined at an angle (or referred to as an inclination angle) to the first direction D1.

From the above, it can be understood that in order to achieve the expected generation of turbulent flow to enhance heat dissipation effect, the length directions D3 and D4 of the ribs 15 and 15' are set in a way that is not parallel to the first direction D1.

When the cover 14 covers the base 11, the ribs 15 are inserted into the flow channels 13 defined by the parallel curved fins 12. That is, the ribs 15 cause interference to the fluids flowing in the flow direction (first direction D1) in the flow channels 13 to form turbulent flow.

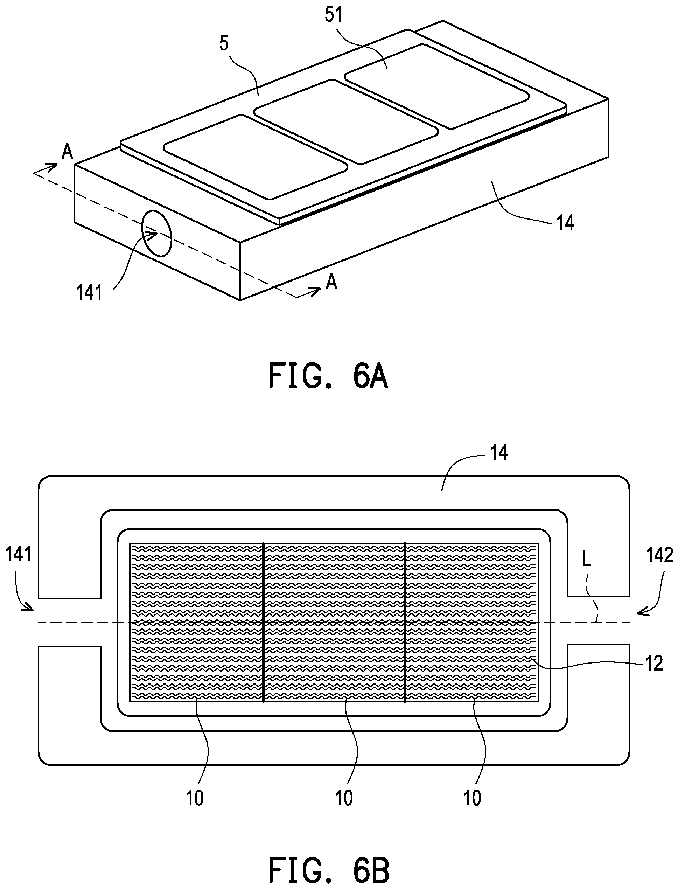

FIG. 6A is a schematic view of the heat sink applied in a thermal module, and FIG. 6B is a top view of a cross-section taken along the A-A section line of FIG. 6A. With reference to FIG. 4A, FIG. 6A, and FIG. 6B together, a thermal module 6 of this embodiment includes a power semiconductor element 51, a plurality of heat sinks 10, and a cover 14. The power semiconductor element 51 may be, for example, an insulated gate bipolar transistor (IGBT), a metal-oxide-semiconductor field-effect transistor (MOSFET), or a silicon carbide for semiconductor component. The cover 14 has a fluid inlet 141 and a fluid outlet 142, and centers of the fluid inlet 141 and the fluid outlet 142 are on a same extension line L. The power semiconductor element 51 and the heat sinks 10 sandwich the cover 14 therebetween. The plurality of heat sinks 10 are arranged on the cover 14, and when the cover 14 covers the heat sinks 10, an approximately enclosed space is formed, and fluids may only flow in and out through the fluid inlet 141 and the fluid outlet 142 of the cover 14. The parallel curved fins 12 of the heat sinks 10 define multiple flow channels 13 extending in the first direction D1, where the flow channels 13 of adjacent heat sinks 10 are connected in series with each other, and the extension line L is parallel to the first direction D1.

This arrangement structure may also be applied in the electronic device 2 (shown in FIG. 3B), where the heat source accompanying the operation of the power semiconductor element 51 may be set according to the multiple flow channels corresponding to high flow rates in the electronic device 2 (shown in FIG. 3B), but it is not limited thereto, and arrangement may be made according to actual conditions.

### Second Embodiment

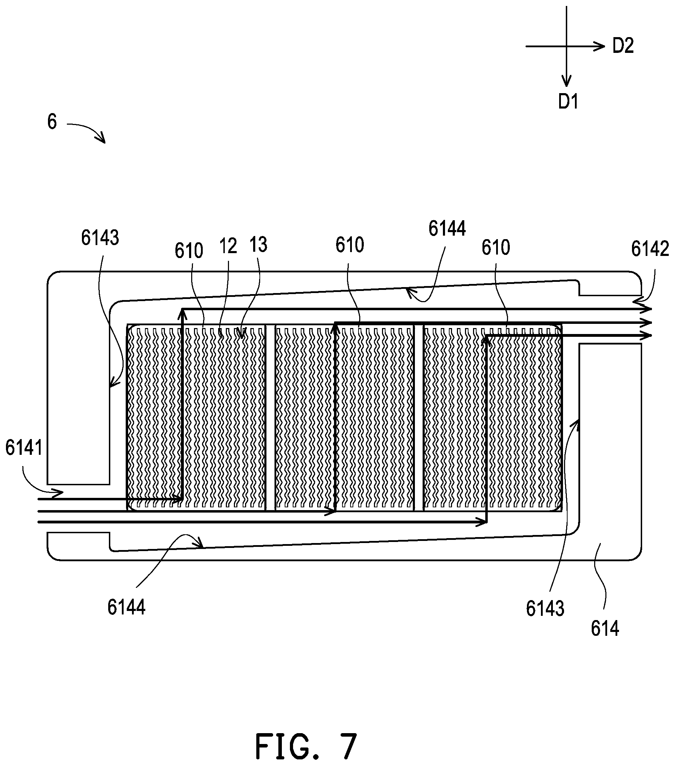

FIG. 7 is a schematic view of the thermal module according to the second embodiment of the disclosure. With reference to FIG. 7, the thermal module 6 of this embodiment includes the power semiconductor element 51 (shown in FIG. 6A), a plurality of heat sinks 610, and a cover 614. The power semiconductor element 51 (shown in FIG. 6A) and the heat sinks 610 sandwich the cover 614 therebetween. Description of the power semiconductor element 51 is provided in the foregoing paragraphs and thus is not repeated herein.

The cover 614 has a fluid inlet 6141 and a fluid outlet 6142. Different from the foregoing embodiments, in this embodiment, centers of the fluid inlet 6141 and the fluid outlet 6142 are not on the same extension line L (shown in FIG. 6B). In other words, the fluid inlet 6141 and the fluid outlet 6142 are misaligned. To be specific, the fluid inlet 6141 is arranged close to a second side of the cover 614, while the fluid outlet 6142 is arranged close to a first side of the cover 614.

The plurality of heat sinks 610 are arranged on the cover 614, and the heat sinks 610 are located between the fluid inlet 6141 and the fluid outlet 6142. When the cover 614 covers the heat sinks 610, the cover 614 forms an approximately enclosed space, and fluids may only flow in and out through the fluid inlet 6141 and the fluid outlet 6142 of the cover 614.

Another difference from the foregoing embodiments is that the parallel curved fins 12 define multiple flow channels 13 extending in the first direction, where the flow channels 13 of adjacent heat sinks 610 are arranged in parallel with each other. To be specific, the extending direction of the flow channels 13 (or the flow direction of the fluids in the flow channels 13) (first direction D1) is perpendicular to a depth direction (second direction D2) of the fluid inlet 6141 (or fluid outlet 6142). In one embodiment, the length direction D3 of these ribs 15 is approximately perpendicular to the depth direction (second direction D2) of the fluid inlet 6141 (or fluid outlet 6142), and the length direction D3 is inclined at an angle (or referred to as an inclination angle) in the second direction D2. Under the premise of achieving generation of turbulent flow to enhance heat dissipation effect, the inclination angle is between ±5% to ±10% error of a right angle, including ±5% and ±10%.

In addition, to facilitate rapid fluid flow into the flow channels 13, a boundary of an inner sidewall of the cover 614 may be designed as a parallelogram. To be specific, one pair of inner sidewalls 6143 of the cover 614 is set parallel to the first direction D1, while the other pair of inner sidewalls 6144 is set inclined to the second direction D2, so that when fluids enter the cover 614 from the fluid inlet 6141, the fluids are guided by the inner sidewalls 6144 to enter the flow channels 13 of individual heat sinks 610 more quickly and comprehensively.

The heat sinks 10 of the aforementioned first embodiment are arranged in series, and as the fluid flows sequentially through the first heat sink 10, the second heat sink 10, the third heat sink 10..., the temperature of the fluid entering from the fluid inlet 141 becomes increasingly higher after passing through multiple heat sinks 10 in sequence, which may easily lead to heat accumulation. In comparison, the heat sinks 610 of this embodiment are arranged in parallel, so that the fluids entering different heat sinks 610 independently perform heat exchange in the individual heat sinks 610 and are less susceptible to heat accumulation due to the influence of fluids flowing through other heat sinks 610. Therefore, the parallel arrangement of the heat sinks 610 may more effectively enhance heat dissipation compared to the series arrangement of the heat sinks 610.

In the thermal module 6 of this embodiment, the heat sinks 610 may use curved fins 12 with the same pitch P. To be specific, each of the parallel-arranged curved fins 12 has multiple pitches P, and the pitches P owned by each curved fin 12 are the same. That is, a value of each pitch P owned by each of all the curved fins 12 is fixed.

Additionally, any of the heat sinks 10 exemplified in the aforementioned first embodiment may also be used. For instance, although the foregoing description is based on the example that the pitch P of all the curved fins 12 is a single value, in another unillustrated variation, each curved fin 12 may have the same pitch P, but the pitch P of the first curved fin 12 may differ from the pitch P of an adjacent second curved fin 12.

In various embodiments, the heat sink, the electronic device incorporating the heat sink, and the thermal module enhance overall heat dissipation efficiency through a specific structural arrangement. When a fluid (e.g., liquid or gas) enters the flow channel between two adjacent curved fins, the fluid's direction and velocity change according to the bending angle and width of the flow channel. This results in increased turbulence and local flow rate in microscopic regions, leading to a reduction in temperature associated with the operation of the power component.

## Claims

1. A heat sink (10, 610), comprising:
a base (11); and
a plurality of curved fins (12, 12A, 12B) arranged in parallel on the base (11), wherein each curved fin (12, 12A, 12B) has a plurality of wave peaks (12a), with a pitch (P) defined between any two adjacent wave peaks (12a), and at least two of the plurality of wave peaks (12a) are different.

2. An electronic device (2), comprising:
a power component (5), comprising:
a substrate (52) made of a semiconductor material, having a first contact surface (521) and a second contact surface (522) on two opposite sides;
a first metal layer (53) on the first contact surface (521);
a second metal layer (54) on the second contact surface (522); and
a plurality of power semiconductor elements (51) on the first metal layer (53); and
a heat sink (10, 610) on the power component (5) and comprising:
a base (11) on the second metal layer (54); and
a plurality of curved fins (12, 12A, 12B) arranged in parallel on the base (11), each curved fin (12, 12A, 12B) having a plurality of wave peaks (12a), with a pitch (P) defined between any two adjacent wave peaks (12a), wherein each curved fin (12, 12A, 12B) has at least one first pitch (P1) and one second pitch (P2), the first pitch (P1) being greater than the second pitch (P2).

3. A thermal module (6), comprising:
at least one power semiconductor element (51), a plurality of heat sinks (10, 610), and a cover (14, 614) having a fluid inlet (141, 6141) and a fluid outlet (142, 6142), wherein the power semiconductor element (51) and the plurality of heat sinks (10, 610) are positioned between the fluid inlet (141, 6141) and the fluid outlet (142, 6142), with the power semiconductor element (51) and the plurality of heat sinks (10, 610) sandwiching the cover (14, 614), and each heat sink (10, 610) comprises a base (11) and a plurality of curved fins (12, 12A, 12B) arranged in parallel on the base (11), wherein the plurality of curved fins (12, 12A, 12B) arranged in parallel define a plurality of flow channels (13), the flow channels (13) extend in a first direction (D1), and a depth direction of the fluid inlet (141, 6141) defines a second direction (D2), wherein the first direction (D1) is perpendicular to the second direction (D2).

4. An electronic device (2) comprising a plurality of power semiconductor elements (51) and a heat sink (10, 610) comprising a base (11) and a plurality of curved fins (12, 12A, 12B) arranged in parallel on the base (11), the plurality of curved fins (12, 12A, 12B) having different shapes, two adjacent curved fins (12, 12A, 12B) defining a flow channel (13), each flow channel (13) configured to accommodate a fluid with a flow rate, wherein the flow rates in the plurality of flow channels (13) are not the same, and the plurality of power semiconductor elements (51) are positioned on the base (11) corresponding to the flow channels (13) with higher flow rates.

5. The electronic device (2) according to claims 1, 2, 3, or 4, wherein curved shapes of two adjacent curved fins (12, 12A, 12B) arranged in parallel are different.

6. The electronic device (2) according to claims 1, 2, 3, or 4, wherein the heat sink (10, 610) further comprises a cover (14, 614) covering the base (11), and the plurality of curved fins (12, 12A, 12B) are located in a space formed by the cover (14, 614) and the base (11).

7. The electronic device (2) according to claims 1, 2, 3, or 4, wherein the cover (14, 614) has a first surface (14a) facing the base (11), the plurality of curved fins (12, 12A, 12B) have a second surface (12b) facing the cover (14, 614), and the second surface (12b) has a varying distance from the first surface (14a).

8. The electronic device (2) according to claims 1, 2, 3, or 4, wherein the plurality of heat sinks (10, 610) further comprise a plurality of ribs (15, 15') arranged in the flow channels (13), wherein a length direction (D3, D4) of the ribs (15, 15') is perpendicular or inclined to a first direction (D1), and the first direction (D1) is an extending direction of the flow channels (13).

9. The electronic device (2) according to claims 1, 2, 3, or 4, wherein surfaces of the plurality of curved fins (12, 12A, 12B) on both sides of each of the flow channels (13) have different surface roughness.

10. The electronic device (2) according to claims 1, 2, 3, or 4, wherein each curved fin (12, 12A, 12B) has a plurality of wave peaks (12a), and heights (H) of the plurality of wave peaks (12a) are different.

11. The electronic device (2) according to claims 1, 2, 3, or 4, wherein thicknesses (T) of the plurality of curved fins (12, 12A, 12B) are different.

12. The electronic device (2) according to claims 1, 2, 3, or 4, wherein widths (W) of the plurality of curved fins (12, 12A, 12B) are different.

## Amended claims

### Amended claims in accordance with Rule 137(2) EPC.

1. A heat sink (10, 610), comprising:
a base (11); and
a plurality of curved fins (12, 12A, 12B) arranged in parallel on the base (11), wherein each curved fin (12, 12A, 12B) has a plurality of wave peaks (12a) along a length direction of the curved fins (12, 12A, 12B), with a pitch (P) defined between any two adjacent wave peaks (12a),
**characterized in that** the pitch (P) comprising at least a first pitch (P1) and a second pitch (P2), wherein the first pitch (P1) is larger than the second pitch (P2), the first pitch (P1) and the second pitch (P2) are arranged repeatedly or alternatively, whereas any three continuous pitches (P) has at least one of the first pitch (P1) and at least one of the second pitch (P2), and the any three continuous pitches (P) occurs at least once on the curved fins (12, 12A, 12B).

2. An electronic device (2), comprising:
a power component (5), comprising:
a substrate (52), having a first contact surface (521) and a second contact surface (522) on two opposite sides;
a first metal layer (53) on the first contact surface (521);
a second metal layer (54) on the second contact surface (522); and
a plurality of power semiconductor elements (51) on the first metal layer (53); and
a heat sink (10, 610) according to claim 1, disposed on the power component (5).

3. A thermal module (6), comprising:
at least one power semiconductor element (51), a plurality of heat sinks (10, 610) according to claim 1, and a cover (14, 614) having a fluid inlet (141, 6141) and a fluid outlet (142, 6142), wherein the power semiconductor element (51) and the plurality of heat sinks (10, 610) are positioned between the fluid inlet (141, 6141) and the fluid outlet (142, 6142),
**characterized in that** the cover (14, 614) is fixed to the base (11); the connection of the cover (14, 614) and the base (11) defines a space in which the curved fins (12, 12A, 12B) are arranged, whereby the cover (14, 614) and the base (11) enclose the flow channels (13), the power semiconductor element (51) being disposed on a side of the base (11) opposite to the cover (14, 614); and
the flow channels (13) extend in a first direction (D1), and a depth direction of the fluid inlet (141, 6141) defines a second direction (D2), wherein the first direction (D1) is perpendicular to the second direction (D2).

4. An electronic device (2) comprising a plurality of power semiconductor elements (51) and a heat sink (10, 610) according to claim 1, wherein two adjacent curved fins (12, 12A, 12B) defining a flow channel (13),
**characterized in that**
the plurality of flow channels (13) exhibit mutually different flow rates along their extending direction, and the plurality of power semiconductor elements (51) are positioned on the base (11) in correspondence with the flow channels (13) at locations of higher flow rate.

5. The electronic device (2) according to claims 2 or 4, wherein curved shapes of two adjacent curved fins (12, 12A, 12B) arranged in parallel are different.

6. The electronic device (2) according to claims 2 or 4, wherein the heat sink (10, 610) further comprises a cover (14, 614) covering the base (11), and the plurality of curved fins (12, 12A, 12B) are located in a space formed by the cover (14, 614) and the base (11).

7. The electronic device (2) according to claims 2 or 4, wherein the cover (14, 614) has a first surface (14a) facing the base (11), the plurality of curved fins (12, 12A, 12B) have a second surface (12b) facing the cover (14, 614), and the second surface (12b) has a varying distance from the first surface (14a).

8. The electronic device (2) according to claims 2 or 4, wherein the plurality of heat sinks (10, 610) further comprise a plurality of ribs (15, 15') arranged in the flow channels (13), wherein a length direction (D3, D4) of the ribs (15, 15') is perpendicular or inclined to a first direction (D1), and the first direction (D1) is an extending direction of the flow channels (13).

9. The electronic device (2) according to claims 2 or 4, wherein surfaces of the plurality of curved fins (12, 12A, 12B) on both sides of each of the flow channels (13) have different surface roughness.

10. The electronic device (2) according to claims 2 or 4, wherein each curved fin (12, 12A, 12B) has a plurality of wave peaks (12a), and heights (H) of the plurality of wave peaks (12a) are different.

11. The electronic device (2) according to claims 2 or 4, wherein thicknesses (T) of the plurality of curved fins (12, 12A, 12B) are different.

12. The electronic device (2) according to claims 2 or 4, wherein widths (W) of the plurality of curved fins (12, 12A, 12B) are different.
